# EUROPEAN PATENT APPLICATION

(11) **EP 4 027 468 A1**
(43) Date of publication of application: **13.07.2022**
(21) Application number: 20860272.2
(22) Date of filing: 10.07.2020
(51) Int. Cl.: H01S 5/022, H01S 5/14, H01S 5/40

(54) **LASER OSCILLATION DEVICE**

(30) Priority: 06.09.2019 JP 2019163218
(71) Applicant: Panasonic Intellectual Property Management Co., Ltd., Osaka-shi, Osaka 540-6207 (JP)
(72) Inventor: YOSHIDA Takayuki, Osaka-shi, Osaka 540-6207 (JP); KASSAI Takaaki, Osaka-shi, Osaka 540-6207 (JP); NAKAI Izuru, Osaka-shi, Osaka 540-6207 (JP)
(74) Representative: Vigand, Philippe
(86) International application number: PCT/JP2020/026983
(87) International publication number: WO 2021/044730

(57) **Abstract**

Provided is a laser oscillation device including: a plurality of semiconductor laser diodes (1a to le); optical component (5) that directs a plurality of laser beams emitted from the plurality of semiconductor laser diodes in a specific direction to generate a superimposed laser beam including the plurality of laser beams and propagating in the specific direction; and optical switching element (130) that receives the superimposed laser beam from optical component (5). The superimposed laser beam has a plurality of wavelengths.

## Description

### TECHNICAL FIELD

The present invention relates to a laser oscillation device of a direct diode laser system, being mainly used for machining applications such as cutting and welding.

### BACKGROUND ART

Techniques forming a laser oscillation device include a technique of combining a plurality of lasers emitted from a plurality of laser sources to form one laser (e.g., see PTL 1).

In recent years, a laser oscillation device of a direct diode system (DDL system) using a laser diode (LD) as a laser source of the above technique has been fabricated. The laser oscillation device of the DDL system can be used for direct machining by taking advantage of high oscillation efficiency of the laser diode.

### Citation List

### Patent Literature

PTL 1: US Patent No. 6208679

### SUMMARY OF THE INVENTION

### Technical problem

Unfortunately, fabricating a laser oscillation device that generates a laser beam having a stable output based on the above-described DDL system has been difficult.

### Solution to problem

In view of the above, an aspect of the present invention relates to a laser oscillation device including: a plurality of semiconductor laser diodes; an optical component that directs a plurality of laser beams emitted from the plurality of semiconductor laser diodes in a specific direction to generate a superimposed laser beam including the plurality of laser beams and propagating in the specific direction; and an optical switching element that receives the superimposed laser beam from the optical component, the superimposed laser beam having a plurality of wavelengths.

### Advantageous effect of invention

The present invention enables easily fabricating a laser oscillation device that generates a laser beam having a stable output while the DDL system is used.

### BRIEF DESCRIPTION OF DRAWINGS

FIG. 1 is a schematic diagram illustrating a configuration of a laser beam generation unit of a laser oscillation device according to an exemplary embodiment of the present invention.
FIG. 2 is a block diagram illustrating a schematic configuration of the laser oscillation device according to the exemplary embodiment of the present invention.

### DESCRIPTION OF EMBODIMENT

A laser oscillation device according to the present exemplary embodiment includes: a plurality of semiconductor laser diodes (hereinafter, also simply referred to as "LD"); an optical component that directs a plurality of laser beams emitted from the plurality of semiconductor laser diodes in a specific direction to generate a superimposed laser beam including the plurality of laser beams and propagating in the specific direction; an optical switching element that receives the superimposed laser beam from the optical component; and an output mirror located on an optical path of the superimposed laser beam. The optical component is, for example, a diffraction grating, but may be a medium that refracts light, such as a prism.

Hereinafter, a configuration of the laser oscillation device according to the present exemplary embodiment will be described in more detail with reference to the drawings.

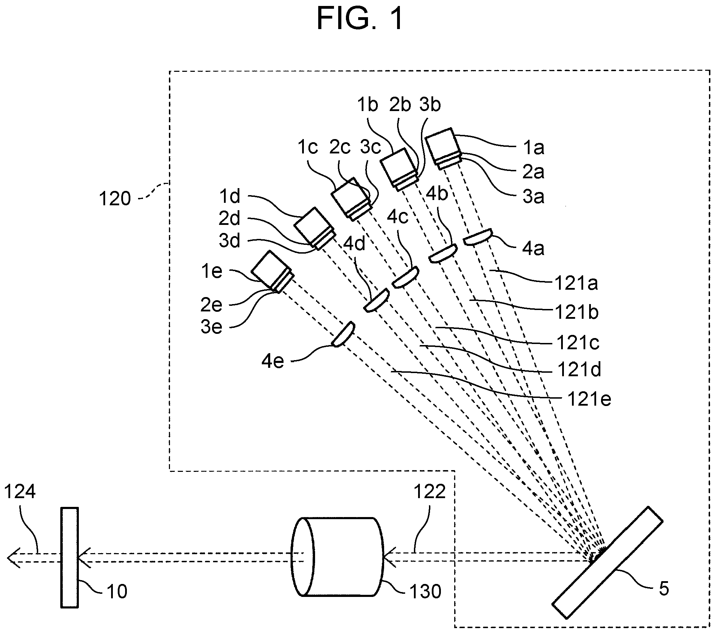

FIG. 1 is a schematic diagram illustrating a configuration of a laser beam generation unit being a core of the laser oscillation device according to the present exemplary embodiment, and is a diagram schematically illustrating laser beam generation by the DDL system. FIG. 1 illustrates semiconductor laser diodes (LD) 1a to 1e that emit laser beams 121a to 121e, respectively. Laser beams 121a to 121e are incident on diffraction grating 5 respectively through first collimators 2a to 2e, rotating elements 3a to 3e, and second collimators 4a to 4e. Diffraction grating 5 receives laser beams 121a to 121e and generates one superimposed laser beam 122 including laser beams 121a to 121e. Superimposed laser beam 122 is emitted toward the outside through optical switching element 130 and output mirror 10. First collimators 2a to 2e, rotating elements 3a to 3e, second collimators 4a to 4e, and diffraction grating 5 constitute laser beam synthesizing unit 120 as a whole.

In FIG. 1, each of LDs 1a to 1e forms a set of a corresponding one of first collimators 2a to 2e, a corresponding one of rotating elements 3a to 3e, and a corresponding one of second collimators 4a to 4e. Although a number of LDs is five in FIG. 1, the present exemplary embodiment is not limited in the number of LDs. The number of LDs can be adjusted in accordance with desired output energy of laser.

### (Semiconductor laser diode (LD))

LDs 1a to 1e generate laser beams 121a to 121e, respectively. The LD is, for example, an LD chip in a chip-like shape. As the LD chip, an LD chip of edge emitting laser (EEL) is preferably used. The LD chip of edge emitting laser, for example, includes a resonator in a long bar-like shape formed parallel to a substrate surface in the chip. The resonator has first and second end surfaces that are spaced apart in a longitudinal direction of the resonator. The first end surface is covered with a first reflection film having a first high reflectance to substantially totally reflect a laser beam. In contrast, the second end surface is covered with a second reflection film having a second high reflectance smaller than the first high reflectance. Laser beams amplified and aligned in phase by reflection on the first and second end surfaces are emitted from the second end surface. The resonator has a longitudinal length that is referred to as a cavity length (CL).

The LD chip may include a plurality of resonators to emit a plurality of laser beams. In this case, the laser beams can be emitted from respective positions on the second end surface. That is, the LD may have a plurality of light emission points. The light emission points may be one-dimensionally aligned along an end surface of the chip, which is the second end surface of the resonator.

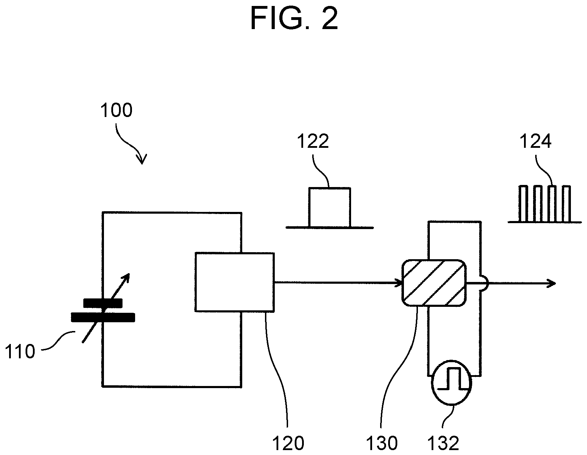

LDs 1a to 1e are connected to constant current source 110 (see FIG. 2). LDs 1a to 1e may be connected in series or in parallel with constant current source 110.

Laser beams 121a to 121e each have a wavelength band in which high power (gain) is obtained. This wavelength band has a certain width. The wavelength band in which high power (gain) is obtained can change depending on temperature of the LD chip, i.e., depending on length of a period of time in which LDs 1a to 1e are driven. LDs 1a to 1e of the present exemplary embodiment are each configured such that the wavelength band in which high power (gain) is obtained includes a locked wavelength to be described later at a time point when a sufficient time has elapsed from a start of driving each of LDs 1a to 1e and output of a laser beam emitted from each of LDs 1a to 1e has been stabilized.

Although the laser beam is not particularly limited in wavelength, an infrared laser having a peak wavelength of 975 ± 25 nm or 895 ± 25 nm, a blue laser having a peak wavelength of 400 nm to 425 nm, or the like can be used, for example.

### (First collimator)

Laser beams 121a to 121e emitted respectively from LDs 1a to 1e are all diffused along with propagation to be increased in beam width. First collimators 2a to 2e respectively collimate laser beams 121a to 121e in a first direction. That is, first collimators 2a to 2e respectively prevent expansion of laser beams 121a to 121e in beam width in the first direction, and collimate laser beams 121a to 121e to be substantially constant in beam width in the first direction. The first direction may maximize the expansion in beam width. The first direction is, for example, a direction perpendicular to the substrate surface of the LD chip. The direction perpendicular to the substrate surface of the LD chip may generally be a direction of a fast axis of a laser beam emitted from the LD chip. In contrast, a direction parallel to the substrate surface of the LD chip and along a beam emission surface can be generally a direction of a slow axis of the laser beam emitted from the LD chip. First collimators 2a to 2e are, for example, convex lenses.

### (Rotating element)

Rotating elements 3a to 3e respectively receive laser beams 121a to 121e collimated in the first direction from first collimators 2a to 2e, and rotate laser beams 121a to 121e. "Rotating a beam" in the above description means that a sectional shape of the beam is rotated in a plane perpendicular to a propagation direction of the beam.

At least one of LDs 1a to 1e may be an LD chip having a plurality of light emission points. Any of LDs 1a to 1e may have a plurality of light emission points. For example, when LD 1a is an LD chip having a plurality of light emission points, laser beams corresponding to the light emitting points are generated and emitted, and then are diffused along with propagation to be increased in beam width. Rotating element 3a rotates a sectional shape of each of the laser beams to reduce superimposition between the laser beams different in light emission point. As a result, a high-power laser beam is obtained.

Before passing through rotating element 3a, the laser beams different in light emission point are aligned in a direction parallel to the substrate surface of the LD chip and along the beam emission surface (chip end surface). The laser beams have been subjected to collimation with first collimator 2a, and thus have a flat sectional shape (e.g., an ellipse or a square) with a minor axis in the first direction. For example, rotating element 3a rotates the laser beams in an elliptical shape in section such that an angle formed by a direction of a major axis of the elliptical shape and the substrate surface approaches a right angle, i.e., such that an angle formed by a direction of the minor axis and the substrate surface approaches zero degrees. When the first direction is perpendicular to the substrate surface of the LD chip, for example, the laser beams can be rotated by 90° by rotating element 3a. Rotating element 3a is, for example, composed of a convex lens that is a cylindrical lens having an axis perpendicular to the emission direction of the laser beams and inclined at, for example, 45° with respect to the substrate surface, and that is disposed along an alignment direction of the light emission points.

First collimators 2a to 2e and rotating elements 3a to 3e can be attached to LDs 1a to 1e, respectively. Then, the laser oscillation device can be assembled by using a component in which the corresponding one of LDs 1a to 1e, the corresponding one of first collimators 2a to 2e, and the corresponding one of rotating elements 3a to 3e are integrated.

### (Second collimator)

Second collimators 4a to 4e respectively receive laser beams 121a to 121e collimated in the first direction by corresponding first collimators 2a to 2e, and collimate these laser beams 121a to 121e in a second direction. That is, second collimators 4a to 4e prevent expansion of the laser beams, which are collimated in the first direction by first collimators 2a to 2e, in beam width in the second direction, and collimate the laser beams to be substantially constant in beam width in the second direction. Second collimators 4a to 4e preferably may collimate laser beams passing through rotating elements 3a to 3e after passing through first collimators 2a to 2e, respectively. When rotating elements 3a to 3e are not provided, the second direction is different from the first direction, and is, for example, perpendicular to the first direction. When rotating elements 3a to 3e are provided, the second direction is different from the first direction after rotation by the rotating elements, and is, for example, perpendicular to the first direction after the rotation thereof. When rotating elements 3a to 3e rotate the laser beams by 90°, the first direction and the second direction may be parallel to each other. The second direction may be the direction of the slow axis of the laser beams emitted from the LD chip. Second collimators 4a to 4e are, for example, convex lenses.

### (Diffraction grating)

Diffraction grating 5 receives laser beams 121a to 121e respectively emitted from LDs 1a to 1e and passing through first collimators 2a to 2e, rotating elements 3a to 3e, and second collimators 4a to 4e. Diffraction grating 5 directs received laser beams 121a to 121e in a specific direction independent of LDs 1a to 1e, thereby generating superimposed laser beam 122 propagating in the specific direction. Superimposed laser beam 122 includes laser beams 121a to 121e each directed in the specific direction. Diffraction grating 5 may be a reflection type or a transmission type.

LDs 1a to 1e are disposed apart from each other in laser oscillation device 100. Thus, laser beams 121a to 121e incident on diffraction grating 5 are inevitably different in incident angle for each of LDs 1a to 1e. In general, a diffraction angle with a maximum diffraction intensity depends on an incident angle. Thus, when laser beams 121a to 121e emitted from LDs 1a to 1e are identical in wavelength, a diffraction angle is different for each of LDs 1a to 1e, and thus it is difficult to direct superimposed laser beam 122 in an identical direction.

However, a diffraction angle also depends on a wavelength. Thus, when laser beams 121a to 121e emitted from LDs 1a to 1e are caused to be different in wavelength from each other, even laser beams 121a to 121e different in incident angle on diffraction grating 5 for each of LDs 1a to 1e can have a constant diffraction angle. As a result, laser beams 121a to 121e emitted from LDs 1a to 1e can be directed in a specific direction. Wavelengths of laser beams 121a to 121e when laser beams 121a to 121e emitted from LDs 1a to 1e are diffracted in the specific direction are each referred to as a locked wavelength. The locked wavelength is different for each of LDs 1a to 1e.

Thus, superimposed laser beam 122 has wavelengths (locked wavelengths) different for each of LDs 1a to 1e. That is, superimposed laser beam 122 includes laser beams 121a to 121e in a superimposed manner, each laser beam having a wavelength distribution having a different locked wavelength at a peak.

Instead of diffraction grating 5, laser beams 121a to 121e emitted from LDs 1a to 1e may be directed in a specific direction using an optical component of a medium that refracts light, such as a prism or a lens.

The laser oscillation device according to the present exemplary embodiment superimposes the plurality of laser beams 121a to 121 emitted from the plurality of LDs 1a to 1e through an optical component such as a diffraction grating (e.g., diffraction grating 5) to generate one laser beam (superimposed laser beam 122). Each of laser beams 121a to 121e emitted from LDs 1a to 1e changes its propagation direction with the optical component. However, LDs 1a to 1e are disposed apart from each other, so that laser beams 121a to 121e incident on the optical component are different in incident angle for each of LDs 1a to 1e. As a result, when the optical component is, for example, a diffraction grating, i.e., when laser beams are identical in wavelength, a diffraction angle with a maximum diffraction intensity from the optical component is also different for each LD. Similarly, when the optical component is, for example, a prism, i.e., when laser beams are identical in wavelength, a transmission angle after refraction is also different for each LD.

However, the diffraction angle and the transmission angle also depend on wavelengths of laser beams 121a to 121e. Thus, adjusting wavelengths of laser beams 121a to 121e to be output for each of LDs 1a to 1e enables the diffraction angle or the transmission angle from the optical component to be substantially constant regardless of LDs 1a to 1e. As a result, laser beams 121a to 121e emitted from the plurality of LDs 1a to 1e are collected into one superimposed laser beam 122 and directed in a specific direction regardless of placement of LDs 121a to 121e. In this case, superimposed laser beam 122 has wavelengths (locked wavelengths) corresponding to respective LDs 1a to 1e.

That is, superimposed laser beam 122 includes laser beams 121a to 121e having respective different lock wavelengths corresponding to the respective LDs. This requires each LD to be individually adjusted in the device by performing filtering based on characteristics of the LD to obtain a high gain at a locked wavelength determined by placement of the LD.

Meanwhile, the laser oscillation device including the LDs needs a certain period of time (e.g., about several seconds) until output is stabilized after a power supply is turned on. This is because a wavelength band in which a high gain is obtained (high gain wavelength band) may change due to a temperature change in a period of time from a time immediately after the power supply is turned on to a time when output is stabilized. Immediately after the power supply is turned on, for example, the high gain wavelength band is on a short wavelength side, and the high gain wavelength band moves to a long wavelength side as temperature rises. Usually, filtering based on characteristics of an individual LD and adjustment of general structure of the oscillation device are required to allow a locked wavelength to exist in a wavelength band having a high gain when output is stabilized.

However, temperature characteristics different for each LD as described above cause extremely strict conditions for performing adjustment of a position of an LD for each placement place and filtering. Consequently, at least one LD may have a locked wavelength out of the high gain wavelength band in its placement. In this case, the laser oscillation device cannot obtain a desired total output.

Thus, the present exemplary embodiment aims to solve the above problem by providing an optical switching element. Action of the optical switching element will be described later.

### (Optical switching element)

Optical switching element 130 receives superimposed laser beam 122 from diffraction grating 5, and transmits (on-state) or blocks (off-state) superimposed laser beam 122 in response to an electric signal applied (e.g., a voltage signal). In the on-state, superimposed laser beam 122 is transmitted or reflected by output mirror 10 to bring an external resonator into an oscillation state. In the off-state, superimposed laser beam 122 traveling toward output mirror 10 is blocked by optical switching element 130. Thus, the external resonator does not oscillate.

When an electric signal is applied to optical switching element 130 with LDs 1a to 1e in which light emission is maintained by the constant current source, output of superimposed laser beam 122 emitted from output mirror 10 can be changed in response to the electric signal. For example, when a pulse signal is applied to optical switching element 130, pulsed laser beam 124 can be extracted from output mirror 10.

In this case, each of LDs 1a to 1e may remain in a drive state during a period of time in which the pulse signal is applied. That is, LDs 1a to 1e may be maintained in a state in which a constant current is applied. This enables a general constant current source to be used to drive LDs 1a to 1e, so that an expensive pulse constant current source is not required to be used. During the application of the pulse signal, the LDs are maintained in a state in which a constant current is applied, so that LDs 1a to 1e are substantially constant in temperature, and thus the high gain wavelength band does not change. Thus, a pulsed laser with stable output can be obtained. The laser oscillation device is also easily switched to generate a continuous laser after generating a pulse laser, and thus is suitable for laser processing applications.

As described above, optical switching element 130 receives superimposed laser beams 121 including laser beams 121a to 122e having a plurality of locked wavelengths. Thus, optical switching element 130 has performance capable of blocking each of laser beams 121a to 121e different in lock wavelength. LDs 1a to 1e have a difference between a longest locked wavelength and a shortest locked wavelength, being usually about 20 nm. Thus, optical switching element 130 having a wavelength band width of 20 nm or more in which a laser beam can be switched is used. The wavelength band width in which a laser beam can be switched is more preferably 50 nm or more.

Superimposed laser beam 122 includes laser beams 121a to 121e emitted from the plurality of LDs 1a to 1e, and thus has a large laser output. Optical switching element 130 capable of blocking a large laser output (e.g., 1 kW or more) is used such that such superimposed laser beam 122 can be blocked.

Optical switching element 130 may include an electro-optic (EO) element or an acousto-optic (AO) element. Examples of the electro-optic element include a Pockels cell. The Pockels cell is made of an electro-optical material in which birefringence changes when voltage is applied. As a result, the electro-optic element is operated as an optical switch by controlling refraction of light or a polarization state in accordance with application of the voltage. Examples of the acousto-optic element include an acousto-optic modulator in which a refractive index periodically changes when an ultrasonic wave is applied. The periodic change in the refractive index acts as a diffraction grating, and thus the acousto-optic element can be used for a switch by outputting diffracted light.

To widen a switchable wavelength bandwidth, optical switching element 130 may be subjected to processing such as covering an incident surface and an emission surface of a laser beam of the Pockels cell with a wideband antireflection film.

Optical switching element 130 does not need to completely block superimposed laser beam 122 from diffraction grating 5 in the off-state, and may reduce output of superimposed laser beam 122 incident on output mirror 10 to the extent that the external resonator stops oscillating. Optical switching element 130 preferably has performance of transmitting 10% or less of output of superimposed laser beam 122, i.e., blocking 90% or more of the output of the laser beams, in the off-state.

A plurality of optical switching elements may be combined to constitute one optical switching element 130 as a whole. For example, first and second optical switching elements may be connected in series such that light emitted from the first optical switching element is incident on the second optical switching element, and then constituting one optical switching element 130 as a whole. In this case, each of the first and second optical switching elements may have performance of transmitting, for example, 30% or less of output of a laser beam, i.e., blocking 70% or more of the output of the laser beam, in the off-state. In the off-state, the output of the laser beam transmitted through optical switching element 130 is reduced to 9% or less, so that optical switching element 130 can be easily fabricated.

Optical switching element 130 may be disposed at a preceding stage of output mirror 10 in an optical path of superimposed laser beam 122, i.e., between diffraction grating 5 and output mirror 10, or may be disposed at a subsequent stage of output mirror 10, i.e., on a side facing diffraction grating 5 across output mirror 10.

### (Output mirror)

Output mirror 10 reflects superimposed laser beam 122 from diffraction grating 5 except for a part of superimposed laser beam 122. Superimposed laser beam 122 reflected by output mirror 10 returns to diffraction grating 5 to be separated into a plurality of laser beams by diffraction grating 5, and then the laser beams return to respective LDs 1a to 1e. This causes laser beams 121a to 121e to externally resonate in laser oscillation device 100 when optical switching element 130 is turned on. A part of superimposed laser beam 122 increased in output by the external resonance passes through output mirror 10 to be emitted to the outside.

FIG. 2 is a block diagram schematically illustrating a configuration of laser oscillation device 100 according to an exemplary embodiment of the present invention. Laser oscillation device 100 includes constant current source 110, laser beam synthesizing unit 120, and optical switching element 130.

Laser beam synthesizing unit 120 is provided with a plurality of LDs driven by constant current source 110. Laser beam synthesizing unit 120 collectively generates one superimposed laser beam 122 from the plurality of laser beams 121a to 121e emitted from the plurality of LDs 1a to 1e. In this state, superimposed laser beam 122 is a continuous wave (CW) output that is constant in output with time. Superimposed laser beam 122 is incident on optical switching element 130. At this time, output of superimposed laser beam 122 passing through optical switching element 130 is modulated in accordance with pulse voltage 132 applied to optical switching element 130. Thus, pulsed laser beam 124 can be extracted. Pulse voltage 132 can be generated by a control circuit built in or externally provided to laser oscillation device 100.

The above-described exemplary embodiment is merely an example of the present invention, and the specific configuration of each unit is not limited to the above-described specific example. Thus, it is needless to say that the configuration can be appropriately modified and designed within a range in which the operation and effect of the present invention are exhibited.

For example, laser beam synthesizing unit 120 may not include all or a part of first collimators 2a to 2e, rotating elements 3a to 3e, and second collimators 4a to 4e. For example, the optical component may receive laser beams 121a to 121e directly from LDs 1a to 1e, respectively.

### INDUSTRIAL APPLICABILITY

The laser oscillation device of the present invention is a laser oscillation device of a direct diode laser system, and is useful for laser processing because of its high power.

### REFERENCE MARKS IN THE DRAWINGS

100: laser oscillation device
10: output mirror
110: constant current source
120: laser beam synthesizing unit
1a to 1e: semiconductor laser diode (LD)
2a to 2e: first collimator
3a to 3e: rotating element
4a to 4e: second collimator
5: diffraction grating
130: optical switching element

## Claims

1. A laser oscillation device comprising:
a plurality of semiconductor laser diodes;
an optical component that directs a plurality of laser beams emitted from the plurality of semiconductor laser diodes in a specific direction to generate a superimposed laser beam including the plurality of laser beams and propagating in the specific direction; and
an optical switching element that receives the superimposed laser beam from the optical component, the superimposed laser beam having a plurality of wavelengths.

2. The laser oscillation device according to claim 1, wherein the optical switching element has a switchable wavelength bandwidth of 20 nm or more.

3. The laser oscillation device according to claim 1 or 2, wherein at least one of the plurality of semiconductor laser diodes has a plurality of light emission points.

4. The laser oscillation device according to any one of claims 1 to 3, further comprising:
a first collimator that collimates the laser beam emitted from at least one of the plurality of semiconductor laser diodes in a first direction;
a rotating element that receives the laser beam collimated in the first direction by the first collimator from the first collimator and rotates the laser beam collimated in the first direction; and
a second collimator that receives the laser beam rotated by the rotating element from the rotating element and collimates the rotated laser beam in a second direction.

5. The laser oscillation device according to any one of claims 1 to 4, wherein the optical switching element includes at least one of a Pockels cell and an acousto-optic element.

6. The laser oscillation device according to any one of claims 1 to 5, wherein
the plurality of laser beams have a plurality of different wavelengths, and
the optical component receives the plurality of laser beams at a plurality of different incident angles corresponding to the plurality of different wavelengths, and emits the plurality of laser beams at an identical emission angle to direct the plurality of laser beams in the specific direction.
